# EUROPEAN PATENT SPECIFICATION

(11) **EP 4 600 597 B1**
(45) Date of publication and mention of the grant of the patent: **26.08.2026**
(21) Application number: 25156477.9
(22) Date of filing: 07.02.2025
(51) Int. Cl.: F28D 15/02, F28D 15/04

(54) **HIGH HEAT COOLING DEVICE**
KÜHLVORRICHTUNG MIT HOHER WÄRMELEISTUNG
DISPOSITIF DE REFROIDISSEMENT À HAUTE CHALEUR

(30) Priority: 11.02.2024 US 202463552149 P
(43) Date of publication of application: 13.08.2025
(73) Proprietor: Purple Cloud Development Pte. Ltd., Singapore 128424 (SG)
(72) Inventor: Lin, Hua-Yuan, 114065 Taipei City (TW); Ke, Shao-Hsuan, 114065 Taipei City (TW)
(74) Representative: Grünecker Patent- und Rechtsanwälte PartG mbB

(56) References cited:
- CN-A- 111 912 274
- TW-U- M 645 321
- US-A1- 2023 047 466
- US-A1- 2023 184 491

## Description

### TECHNICAL FIELD

The present disclosure relates to a high heat cooling device, in particularly to a high heat cooling device with two layers of heat dissipation chambers.

### BACKGROUND OF THE INVENTION

The technical principle of the vapor chamber is similar to that of a heat pipe, but with a different heat conduction method. While the heat pipe conducts heat on a one-dimensional surface, the vapor chamber conducts heat more efficiently because it does so on a two-dimensional surface. Specifically, the vapor chamber comprises a chamber body and a capillary structure. The chamber body includes a hollow chamber filled with a working fluid, and the capillary structure is arranged within the hollow chamber. The heated area of the chamber body is called the evaporation zone, while the area that dissipates heat is called the condensation zone. The working fluid absorbs heat in the evaporation zone and vaporizes. And, the vaporized working fluid rapidly flows throughout the chamber body. The heat from the vaporized working fluid is released in the condensation zone and condensed back into a liquid state. The liquid working fluid then returns to the evaporation zone through the capillary structure, creating a cooling cycle.

Most vapor chambers and heat pipes operate independently, namely conducting only flat or linear heat transfer rather than overall three-dimensional heat transfer. This limits the heat dissipation efficiency. Manufacturers have integrated vapor chambers and heat pipes to create devices capable of conducting three-dimensional heat transfer However, with the rapid development of high-speed computing technologies like artificial intelligence, there is an increasing demand for better heat dissipation in electronic components. The current three-dimensional heat transfer devices cannot properly manage the heat generated during operation. It causes partial dry burning, leading to a decline in function the three-dimensional heat transfer devices. Therefore, it is crucial for R&D personnel to find solutions to prevent functional degradation and maintain the heat dissipation performance of the three-dimensional heat transfer devices.

CN 111 912 274 A discloses a high heat cooling device according to the preamble of claim 1.

### SUMMARY

A variety of additional inventive aspects will be set forth in the description that follows. The inventive aspects can relate to individual features and to combinations of features. It is to be understood that both the forgoing general description and the following detailed description are exemplary and explanatory only and are not restrictive of the broad inventive concepts upon which the embodiments disclosed herein are based.

The invention is as defined in the appended claims. In an embodiment of the present disclosure, a high heat cooling device includes a heat-conducting chamber body having a heat-absorbing surface, a first chamber, and a second chamber, wherein the first chamber is closer to the heat-absorbing surface than the second chamber, and at least one isolation ring disposed in the first chamber of the heat-conducting chamber body, dividing the first chamber into a primary hot zone and a secondary hot zone, wherein the primary hot zone is not in communication with the secondary hot zone, and the primary hot zone is surrounded by the isolation ring and is in communication with the second chamber.

In an embodiment of the present disclosure, the primary hot zone and the secondary hot zone are filled with different types of cooling fluid.

In an embodiment of the present disclosure, the freezing point of the cooling fluid in the primary hot zone is lower than that of the cooling fluid in the secondary hot zone.

In an embodiment of the present disclosure, a cooling fluid filling rate in the primary hot zone is different from that in the secondary hot zone.

In an embodiment of the present disclosure, the cooling fluid filling rate in the primary hot zone is greater than that in the secondary hot zone.

In an embodiment of the present disclosure, the area of the primary hot zone is equal to or greater than 5% of the heat source area, and less than or equal to 80% of the heat source area.

In an embodiment of the present disclosure, the cooling fluid filling rate in the primary hot zone is equal or greater than 60% of the volume of the capillary pore, and the cooling fluid filling rate in the secondary hot zone is at least 50% of the volume of the capillary pore and does not exceed 130% of the volume of the capillary pore.

In an embodiment of the present disclosure, the high heat cooling device further includes a plurality of primary hot zone heat pipes, wherein the plurality of primary hot zone heat pipes are disposed in the heat-conducting chamber body and are in fluid communication with the second chamber and the primary hot zone of the first chamber.

In an embodiment of the present disclosure, at least one primary hot zone heat pipes is positioned outside of the first region that is an area right above the heat-absorbing surface in the heat-conducting chamber body.

In an embodiment of the present disclosure, the high cooling device further includes a plurality of secondary hot zone heat pipes, wherein the secondary hot zone heat pipes are disposed in the heat-conducting chamber body and communicated to the secondary hot zone of the first chamber.

In an embodiment, the secondary hot zone heat pipes are configured to be positioned entirely within the first region, entirely outside of the first region, or in a configuration where some secondary hot zone heat pipes are within in the first region while others are positioned outside of the first region.

In an embodiment of the present disclosure, at least one primary hot zone heat pipe is located on a side of the heat-conducting chamber body along a longitudinal axis.

In an embodiment of the present disclosure, the heat-conducting chamber body includes an air inlet side edge, and the distance from the air inlet side edge to the nearest primary hot zone heat pipe is less than or equal to one-third of the length of the longitudinal axis of the heat-conducting chamber body.

In an embodiment of the present disclosure, a portion of the plurality of primary hot zone heat pipes are located adjacent to the air inlet side edge.

In an embodiment of the present disclosure, the high heat cooling device further includes a plurality of primary hot zone heat pipes, wherein at least one primary hot zone heat pipe is in fluid communication with the primary hot zone, and the number of the primary hot zone heat pipes located on the side adjacent to the air inlet side edge along the longitudinal axis of the heat-conducting chamber body is greater than or equal to 10% of the total number of the primary hot zone heat pipes and the hot zone heat pipes combined together.

In an embodiment of the present disclosure, the high heat cooling device further includes a first heat-conducting casing, a second heat-conducting casing, and at least one partition plate having at least one opening, wherein the partition plate is arranged between the first-heat conducting casing and the second heat-conducting casing, the first chamber and the second chamber are formed by coupling the first heat-conducting casing, the second heat-conducting casing and the partition plate and are located on opposite sides of the partition plate, the heat-absorbing surface is located on a side of the first heat-conducting casing and is further away from the second heat-conducting casing, the isolation ring having a first end and a second end connect to the first heat-conducting casing and the partition plate, respectively, the primary hot zone is communicated to the second chamber via an opening.

In an embodiment of the present disclosure, the thickness of the partition plate is equal to or greater than 0.1 mm and less than or equal to 5 mm.

In an embodiment of the present disclosure, a capillary structure is disposed in both the first chamber and the second chamber.

In an embodiment of the present disclosure, a capillary structure is only disposed on the secondary hot zone of the first chamber.

### BRIEF DESCRIPTION OF THE DRAWINGS

Unless specified otherwise, the accompanying drawings illustrate aspects of the innovative subject matter described herein. Referring to the drawings, wherein like reference numerals indicate similar parts throughout the several views, several examples of high heat cooling devices and methods incorporating aspects of the presently disclosed principles are illustrated by way of example, and not by way of limitation.

The accompanying drawings, which are incorporated in and constitute a part of the description, illustrate several aspects of the present disclosure. A brief description of the drawings is as follows.
FIG. 1 is a schematic perspective view of a high heat cooling device according to one embodiment of the present invention.
FIG. 2 is an exploded schematic view of the high heat cooling device of FIG. 1.
FIG. 3 is a partially enlarged three-dimensional schematic view of the high heat cooling device of FIG. 1.
FIG. 4 is a partially enlarged exploded view of the high heat cooling device of FIG. 1.
FIG. 5 is a schematic plan view of the heat-conducting chamber body of the high heat cooling device of FIG. 1.
FIG. 6 is a schematic plan view of the high heat cooling device of FIG. 1.
FIG. 7 is a schematic cross-sectional view of a high heat cooling device along the line 7-7 of FIG. 6.
FIG. 8 is a schematic cross-sectional view of two cooling fluids flowing in the first chamber and the second chamber respectively in the high heat cooling device of FIG. 1.
FIG. 9 is an exploded schematic diagram of a high heat cooling device according to one embodiment of the present disclosure.
FIG. 10 is a partially enlarged three-dimensional schematic view of the high heat cooling device of FIG. 9.
FIG. 11 is a partially enlarged exploded view of the high heat cooling device of FIG. 9.
FIG. 12 is a schematic plan view of the heat-conducting chamber body of the high heat cooling device of FIG. 9.
FIG. 13 is a schematic plan view of the high heat cooling device of FIG. 9.
FIG. 14 is a schematic cross-sectional view of a high heat cooling device along line 14-14 of FIG. 13.

### DETAILED DESCRIPTION

The following describes various principles related to high heat cooling devices and methods by way of reference to specific examples of vapor chambers and heat pipes including specific arrangements and examples of 'vapor chamber and heat pipe elements described herein' embodying innovative concepts. More particularly, but not exclusively, such innovative principles are described in relation to selected examples of 'vapor chamber and heat pipe elements described herein' systems and methods, and well-known functions or constructions are not described in detail for purposes of succinctness and clarity. Nonetheless, one or more of the disclosed principles can be incorporated in various other embodiments of 'vapor chamber and heat pipe elements described herein' systems and methods to achieve any of a variety of desired outcomes, characteristics, and/or performance criteria.

Thus, "vapor chamber and heat pipe elements described herein" systems and methods having attributes that are different from those specific examples discussed herein can embody one or more of the innovative principles and can be used in applications not described herein in detail. Accordingly, embodiments of 'vapor chamber and heat pipe elements described herein' systems and methods not described herein in detail also fall within the scope of this disclosure, as will be appreciated by those of ordinary skill in the relevant art following a review of this disclosure.

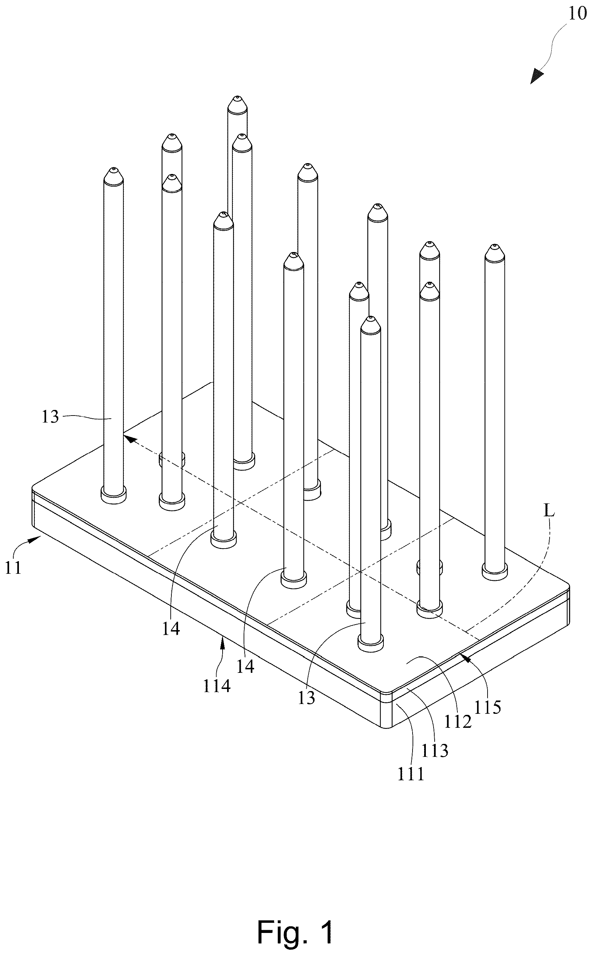

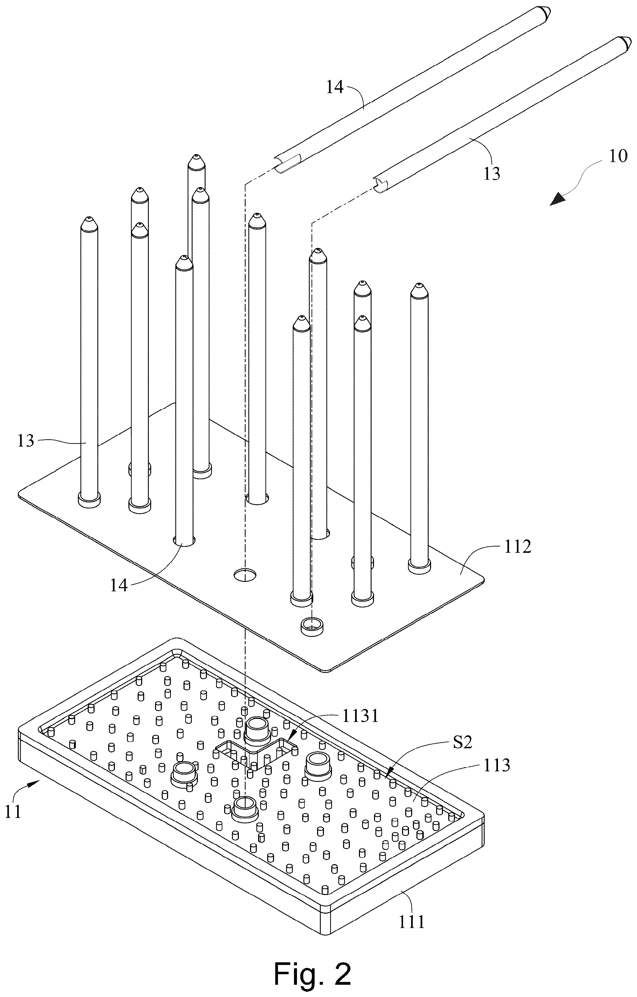

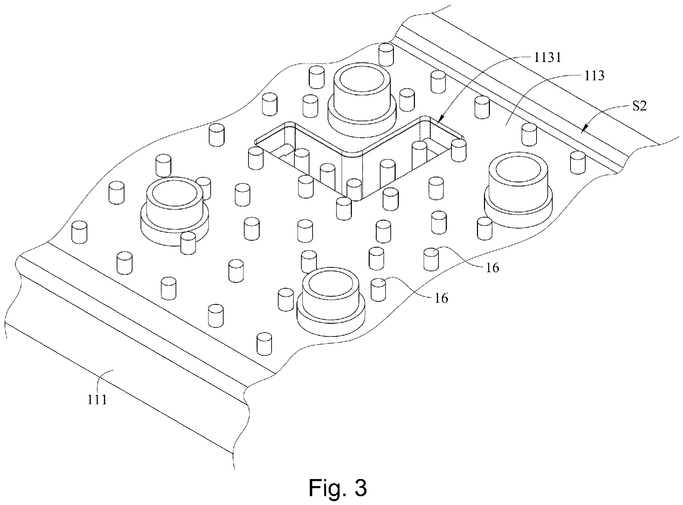

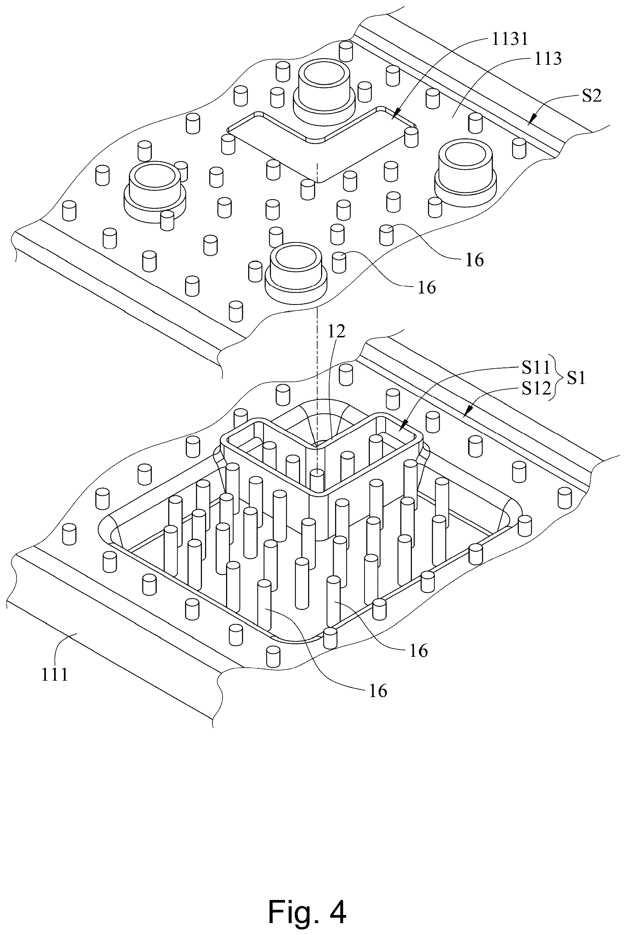

Referring to FIGS. 1 - 4. FIG. 1 is a schematic perspective view of a high heat cooling device according to one embodiment of the present invention. FIG. 2 is an exploded schematic view of the high heat cooling device of FIG. 1. FIG. 3 is a partially enlarged three-dimensional schematic view of the high heat cooling device of FIG. 1. FIG. 4 is a partially enlarged exploded view of the high heat cooling device of FIG. 1.

In one embodiment, the high heat cooling device 10 is used for thermal coupling with a heat source (not shown). The heat source is, for example, a system that includes multiple heating chips or local hot spot in one chip. The high heat cooling device 10 includes a heat-conducting chamber body 11, an isolation ring 12, a plurality of primary hot zone heat pipes 13 and a plurality of secondary hot zone heat pipes 14. The heat-conducting chamber body 11 includes a first heat-conducting casing 111, a second heat-conducting casing 112 and a partition plate 113.

The partition plate 113 is arranged between the first heat-conducting casing 111 and the second heat-conducting casing 112, and the thickness of the partition plate 113 is, for example, equal to or greater than 0.1 mm and less than or equal to 5 mm. The heat-conducting chamber body 11 has a heat-absorbing surface 114. The heat-absorbing surface 114 is thermally coupled to the heat source. Specifically, the heat-absorbing surface 114 refers to the area of the thermal contact area between the first heat-conducting casing 111 and the heat source. In one embodiment, the heat-absorbing surface 114 is smaller than the area of the bottom of the first heat-conducting casing 111. In another embodiment, the heat-absorbing surface 114 is located in the center area of the bottom of the first heat-conducting casing 111. The heat-absorbing surface 114 is located on a side of the first heat-conducting casing 111 and is further away from the second heat-conducting casing 112. Additionally, the first heat-conducting casing 111, the second heat-conducting casing 112 and the partition plate 113 are coupled to form a first chamber S1 and a second chamber S2. The first chamber S1 and the second chamber S2 are respectively located on opposite sides of the partition plate 113. In other words, the second chamber S2 is stacked on the first chamber S1. The first chamber S1 is closer to the heat-absorbing surface 114 than the second chamber S2.

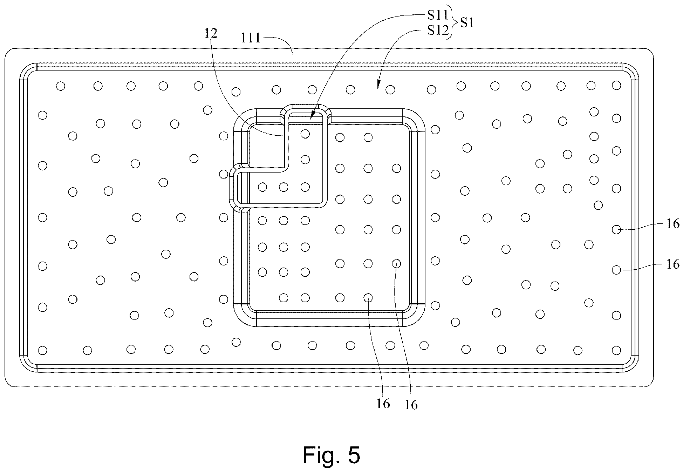

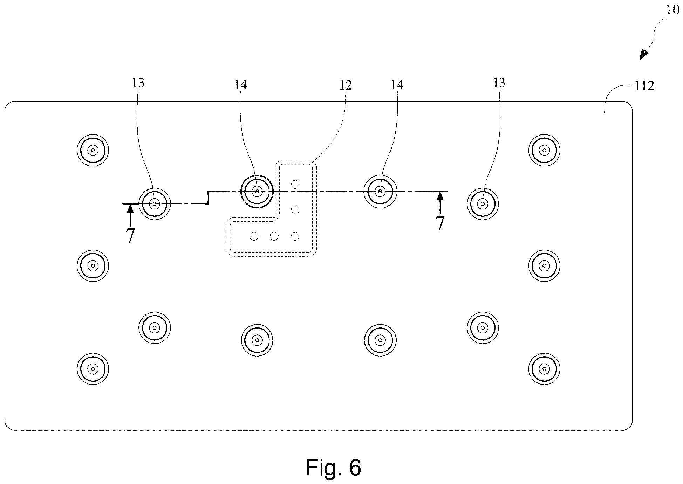

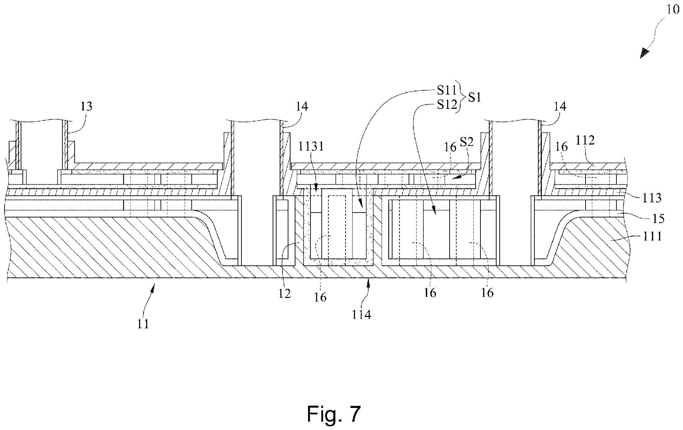

Referring to FIGS. 5-7. FIG. 5 is a schematic plan view of the heat-conducting chamber body of the high heat cooling device of FIG. 1. FIG. 6 is a schematic plan view of the high heat cooling device of FIG. 1. FIG. 7 is a schematic cross-sectional view of a high heat cooling device along the line 7-7 of FIG. 6.

The isolation ring 12 is disposed in the first chamber S1 of the heat-conducting chamber body 11. The isolation ring 12 has two ends, one end connecting to the first heat-conducting casing 111 and the other end connecting to the partition plate 113 to divide the first chamber S1 into a primary hot zone S11 and a secondary hot zone S12. The primary hot zone S11 and the secondary hot zone S12 are not in communication. The primary hot zone S11 is surrounded by the isolation ring 12 and is in communication with the second chamber S2. The isolation ring 12 is, for example, a separate component from the first heat-conducting casing 111 and the partition plate 113, but the embodiment is not limited thereto. In other embodiments, the isolation ring can also be formed integrally by protruding from the first heat-conducting casing or the partition plate. The primary hot zone S11 corresponds to the area with the highest heat density in the heat source, and the value of the heat density of the area with the highest heat density is, for example, 100 watts per square centimeter (W/cm²). Additionally, the partition plate 113 has an opening 1131. The primary hot zone S11 is communicated to the second chamber S2 via the opening 1131.

The primary hot zone S11 and the secondary hot zone S12 are filled with different types of cooling fluids. For example, the cooling fluids may be water, alcohols such as methanol or ethanol, acetone, ammonia, and dielectric liquid such as fluorinated or refrigerant. Additionally, in an embodiment, a capillary structure 15 is disposed in both the first chamber S1 and the second heat-conducting casing 112. By disposing the capillary structure 15, the cooling fluid can absorb heat from the heat source and can vaporize before flowing back through the capillary structure 15. The capillary structure 15 in the primary hot zone S11 can also be used to increase the boiling or evaporation surface area.

In one embodiment, the cooling fluids in the primary hot zone S11 flows to the second chamber S2 through the opening 1131. The filling rate of the cooling fluid in the primary hot zone S11 is, for example, greater than the filling rate of the cooling fluid in the secondary hot zone S12, but the embodiment is not limited thereto. The filling rate of the cooling fluid in the primary hot zone can also be less than or equal to the second hot zone. The filling rate refers to the ratio of the actual filling amount of the cooling fluid to the saturated filling amount of the cooling fluid, and the saturated filling amount of the cooling fluid refers to the product of the volume of the capillary structure, the porosity of the capillary structure and the density of the cooling fluid.

Further, the area of the primary hot zone S11 is, for example, equal to or greater than 5% of the area of the heat-absorbing surface 114 and less than or equal to 80% of the area of the heat-absorbing surface 114. That is to say, the area of the primary hot zone S11 is, for example, equal to or greater than 5% of the area of the heat source area, and less than or equal to 80% of the area of the heat source area.

In one embodiment, the freezing point of the cooling fluid in the primary hot zone S11 is, for example, lower than that of the cooling fluid in the secondary hot zone S12. For example, the cooling fluid in the secondary hot zone S12 is water, and the cooling fluid in the primary hot zone S11 is an alcohol such as methanol or ethanol, a dielectric liquid such as a fluorinated liquid, or a refrigerant with a lower freezing point than that of water. When the external temperature of the high heat cooling device 10 is lower than the freezing point of the cooling fluid in the secondary hot zone S12, the cooling fluid in the secondary hot zone S12 changes to a solid state, and the cooling fluid in the primary hot zone S11 can still maintain its liquid state and flow normally. Accordingly, the cooling fluid located in the primary hot zone S11 can heat the solidified cooling fluid in the secondary hot zone S12 so that the solidified cooling fluid in the secondary hot zone S12 can melt into a liquid state and then resume normal flow.

The primary hot zone heat pipes 13 are disposed in the heat-conducting chamber body 11 and are in fluid communication with the second chamber S2 and the primary hot zone S11 of the first chamber S1. The heat-absorbing surface 114 and spaces right above it in the heat-conducting chamber body 11 define a first region. At least one of the primary hot zone heat pipes 13 is positioned outside the first region. In other words, at least one of the primary hot zone heat pipes 13 falls outside of the area right above heat-absorbing surface 114 in the heat-conducting chamber body 11. In one embodiment, the primary hot zone heat pipes 13 are located on both edge sides of the heat-conducting chamber body 11 along a longitudinal axis L, so that the high cooling device 10 has a symmetrical design, thereby preventing installation person from incorrectly installing the high cooling device in a wrong direction. However, the embodiment is not limited thereto. In one embodiment, the primary hot zone heat pipes 13 are not arranged symmetrically. To enhance the efficiency of the fin utilization, the primary hot zone heat pipes 13 and the secondary hot zone heat pipes 14 can be arranged in a staggered pattern. In another embodiment, the secondary hot zone heat pipes 14 are symmetrically located on both edge sides of the heat-conducting chamber body 11 along a longitudinal axis L. Additionally, some of the primary hot zone heat pipes 13 are positioned in the first region while others are outside of the first region and adjacent to the periphery of the first region. According to the two embodiments mentioned above, the number of the primary hot zone heat pipes 13 can be reduced by 20% and replaced by the secondary hot zone heat pipes 14.

The secondary hot zone heat pipes 14 are disposed in the heat-conducting chamber body 11 and communicated to the secondary hot zone S12 of the first chamber S1. In one embodiment, the secondary hot zone heat pipes 14 are positioned in the first region. In other words, the secondary hot zone heat pipes 14 fall within the area right above heat absorption surface 114 in the heat-conducting chamber body 11. However, the embodiment is not limited thereto. In one embodiment, the secondary hot zone heat pipes 14 are positioned outside of the first region. In other words, the secondary hot zone heat pipes 14 fall outside of the area right above heat absorption surface 114 in the heat-conducting chamber body 11. In another embodiment, while some of the secondary hot zone heat pipes 14 are positioned in the first region, the rest of the secondary hot zone heat pipes are not. In other words, some of the secondary hot zone heat pipes 14 fall within the area right above heat absorption surface 114 in the heat-conducting chamber body 11, while the rest do not. For example, two of the secondary hot zone heat pipes 14 are positioned outside the first region and each replaces a primary hot zone heat pipe 13 adjacent to the first region, and the rest of the secondary hot zone heat pipes 14 are positioned within the first region. The secondary hot zone heat pipes 14 can further dissipate the heat from the heat source. Additionally, in one embodiment, the number of the primary hot zone heat pipes 13 located on the side adjacent to the air inlet side edge 115 along the longitudinal axis L of the heat-conducting chamber body 11 is, for example, greater than or equal to 10% of the total number of the primary hot zone heat pipes 13 and the secondary hot zone heat pipes 14 combined together.

One side of the heat-conducting chamber body 11 is close to a heat dissipation device (not shown) such as a fan. Specifically, the heat-conducting chamber body 11 has an air inlet side edge 115. The air inlet side edge 115 is adjacent to the fan and has a high heat dissipation efficiency. Some of primary hot zone heat pipes 13 are located on a side of the heat-conducting chamber body 11 along a longitudinal axis L, adjacent to the air inlet side edge 115. Accordingly, the cooling fluid in the primary hot zone S11 is heated and vaporized into a gaseous state, and the vaporized cooling fluid flows from the primary hot zone S11 through the second chamber S2 to the primary hot zone heat pipes 13. The cooling airflow generated by the heat dissipation device, such as a fun, flows from the air inlet side edge 115 across the primary hot zone pipes 13, thereby dissipating heat from the gaseous cooling fluid in the primary hot zone heat pipes 13.

In one embodiment, the distance from the air inlet side edge 115 to the nearest primary hot zone heat pipe is, for example, less than or equal to one-third of the length of the longitudinal axis L of the heat-conducting chamber body 11. For example, if the length of the longitudinal axis L is 150 millimeters, the distance from the air inlet side edge 115 to the nearest primary hot zone heat pipe could be 49.5 millimeters.

In one embodiment, when the power of the heat source is low, the primary hot zone S11 and the secondary hot zone S12 are sufficient to dissipate heat from the heat source. When the power of the heat source is high, the cooling fluid in the second chamber S2 flows into the center of the primary hot zone S11 of the first chamber S1 that is in fluid communication with the second chamber S2, and the first chamber S1 and the second chamber S2 work together to dissipate heat from the heat source. Accordingly, it can avoid functional degradation of the high heat cooling device 10 caused by partially dry burning and maintain the heat dissipation performance of the high heat cooling device 10, making the high heat cooling device 10 more efficient. The cooling device 10 is designed to effectively manage heat from systems that include multiple heating chips or local hot spot in one chip.

Specifically, when the power of the primary heat source corresponding to the primary hot zone S11 is greater than or equal to 70% of the total power of the heat source, the primary hot zone S11 can supply a larger power load to increase the heat dissipation efficiency of the heat source because the cooling fluid filling amount of the primary hot zone S11 is greater than that of the secondary hot zone S12. When the power of the primary heat source corresponding to the primary hot zone S11 is less than 70% of the total power of the heat source, the cooling fluid filling rate through the primary hot zone S11 remains greater than or equal to 60% of the volume of the capillary pore and the cooling fluid filling amount would be less than or equal to the 80 % of the volume of the first chamber S1. Accordingly, a mechanism of coexistence of boiling and evaporation can be formed by overfilling the primary hot zone S11 with cooling fluid, thereby preventing the primary hot zone S11 from being partially dry burning due to excessively high temperature of the heat source. Additionally, the cooling fluid filling rate in the secondary hot zone is at least 50% of the volume of the capillary pore and does not exceed 130% of the volume of the capillary pore.

In one embodiment, the high heat cooling device 10 may include a plurality of supporting pillars 16. The supporting pillars 16 protrude from the first heat-conducting casing 111 and the partition plate 113 respectively. The supporting pillars 16 disposed on the first-conducting casing 111 protrude toward the partition plate 113 and at least a portion of the supporting pillars abut against the partition plate 113, and at least a portion of the supporting pillars 16 disposed on the partition plate 114 protrude toward the second heat-conducting casing 112 and abut against the second heat-conducting casing 113. Accordingly, the high heat cooling device 10 can be prevented from expanding or deforming after being heated due to the support of the supporting pillars.

In one embodiment, the high heat cooling device 10 may further include a plurality of heat dissipation fins (not shown). The heat dissipation fins disposed on the primary hot zone heat pipes 13 and the secondary hot zone heat pipes 14 to further improve the heat dissipation efficiency of the high heat cooling device 10.

In one embodiment, there is one partition plate 113, so the heat-conducting chamber body 11 is divided into two chambers S1 and S2 by the partition plate 113, but the embodiment is not limited thereto. In another embodiment, the number of partition plates may be more than two, so the heat-conducting chamber body can be divided into multiple chambers by the partition plates.

In one embodiment, the primary hot zone S11 is communicated with the second chamber S2, but the embodiment is not limited thereto. In another embodiment, the primary hot zone S11 can also be communicated to the first chamber S1.

In the embodiment, the primary hot zone S11 and the secondary hot zone S12 are respectively filled with different types of cooling fluid, but the embodiment is not limited thereto. In another embodiment, the primary hot zone S11 and the secondary hot zone S12 may also be filled with the same type of cooling fluid.

In one embodiment, the filling rate of the cooling fluid in the primary hot zone S11 is greater than the filling rate of the cooling fluid in the secondary hot zone S12, but the embodiment is not limited thereto. In another embodiment, the filling rate of the cooling fluid in the primary hot zone may only need to be different from the filling rate of the cooling fluid in the secondary hot zone.

In one embodiment, there are a plurality of primary hot zone heat pipes 13 and a plurality of secondary hot zone heat pipes 14, but the embodiment is not limited thereto. In another embodiment, the number of the primary hot zone heat pipes and the secondary hot zone heat pipes may respectively only be one each.

In one embodiment, the capillary structures 15 are disposed on both the first chamber S1 and the second chamber S2, but the embodiment is not limited thereto. In another embodiment, for example, the first chamber can be a thermosiphon chamber, and the capillary structures are only disposed on the secondary hot zone of the first chamber so that, following the gaseous cooling fluid in the second chamber condenses into a liquid state, the cooling fluid in liquid state can return to the primary hot zone S11 via gravity.

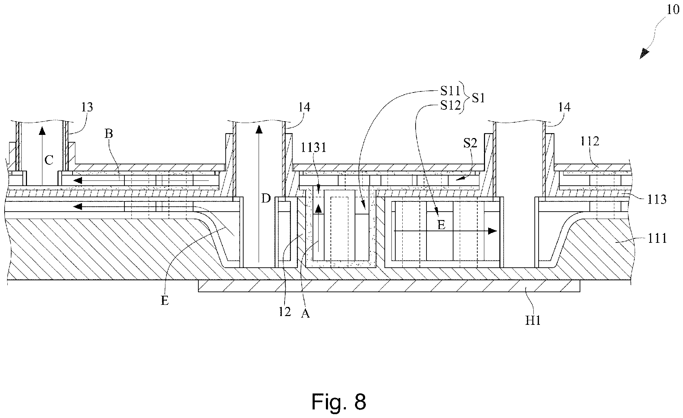

Referring to FIG. 8. FIG. 8 is a schematic cross-sectional view of two cooling fluids flowing in the first chamber and the second chamber respectively in the high heat cooling device of FIG. 1. In one embodiment, the first heat-conducting casing 111 of the high heat cooling device 10 is thermally coupled to the heat source H1 through the heat-absorbing surface 114. When the heat from the heat source H1 is transferred to the primary heat zone S11 through the heat-absorbing surface 114, the cooling fluid in the primary hot zone S11 absorbs the heat and vaporizes into a gaseous state, and the vaporized cooling fluid flows through the opening 1131 along the direction A to the second chamber S2. Subsequently, the vaporized cooling fluid flows in the second chamber S2 along the direction B, and then flows from the second chamber S2 along the direction C to the primary hot zone heat pipe 13. Further, when the heat from the heat source H1 is transferred to the secondary hot zone S12 through the heat-absorbing surface 114, the cooling fluid in the secondary hot zone S12 absorbs the heat and vaporizes into a gaseous state, and the vaporized cooling fluid flows from the first chamber S1 to the secondary hot zone heat pipe 14 along the direction D and the secondary hot zone S12 along the direction E.

When the vaporized cooling fluid is cooled and condensed into a liquid state in the primary hot zone heat pipe 13, it flows in the opposite direction of C from the primary hot zone heat pipe 13 to the second chamber S2, flows in the opposite direction of B through the second chamber S2 to the opening 1131, and then flows in the opposite direction of A though the opening 1131 to the primary hot zone S11 to complete the cooling cycle of the primary hot zone S11, the second chamber S2 and the primary hot zone heat pipe 13. Further, when the vaporized cooling fluid is cooled and condensed into a liquid state in the secondary hot zone heat pipe 14, it flows from the secondary hot zone heat pipe 14 in the opposite direction of D to the first chamber S1 and in the opposite direction of E to the secondary hot zone S12 to complete the cooling cycle of the secondary hot zone S12 and the secondary hot zone heat pipe 14.

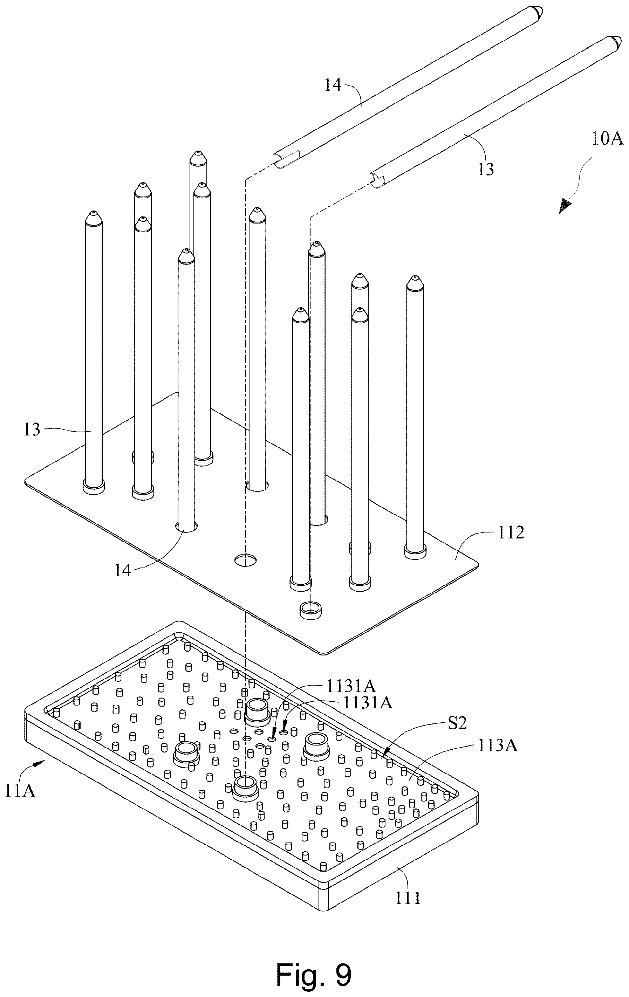

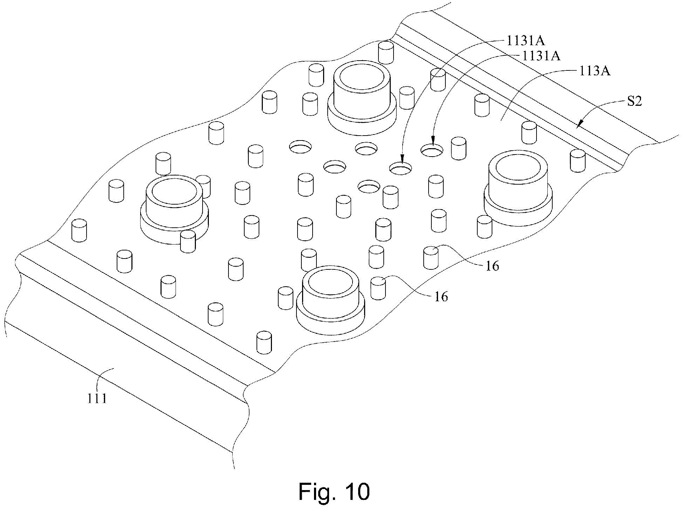

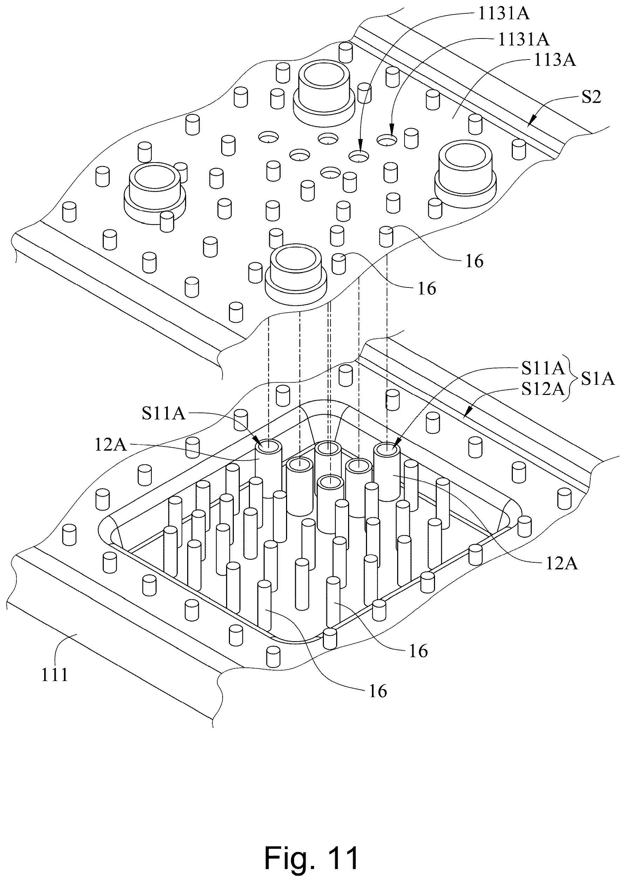

In one embodiment, there is a single isolation ring 12 and a single opening 1131, but the embodiment is not limited thereto. In another embodiment, there may be multiple isolation rings and the partition plate may have multiple openings, referring to FIGS. 9-11. FIG. 9 is an exploded schematic diagram of a high heat cooling device according to one embodiment of the present disclosure. FIG. 10 is a partially enlarged three-dimensional schematic view of the high heat cooling device of FIG. 9. FIG. 11 is a partially enlarged exploded view of the high heat cooling device of FIG. 9.

The high heat cooling device 10A of this embodiment is similar to the high heat cooling device 10, so the differences will be described below, and the similarities will not be repeated. In one embodiment, the high heat cooling device 10A includes a plurality of isolation rings 12A, and the partition plate 113A has a plurality of openings 1131A. At least one of the plurality of isolation rings 12A is, for example, cylindrical. The isolation rings 12A divide the first chamber S1A into a plurality of primary hot zones S11A, and a secondary zone S12A that is not communicated with the plurality of primary hot zones S11A. The primary hot zones S11A are communicated to the second chamber S2 respectively via the corresponding openings 1131A.

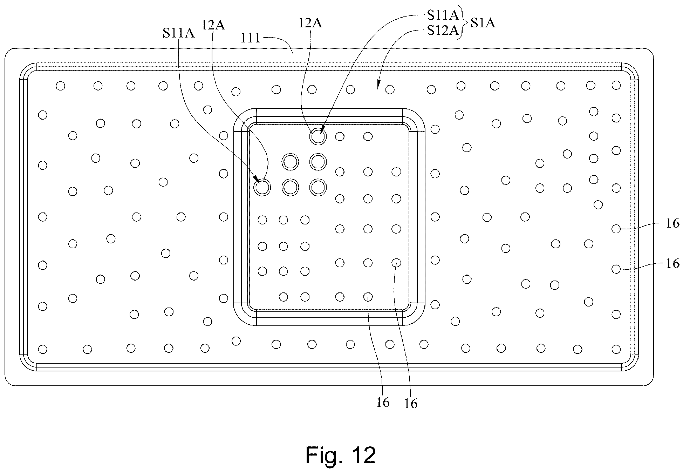

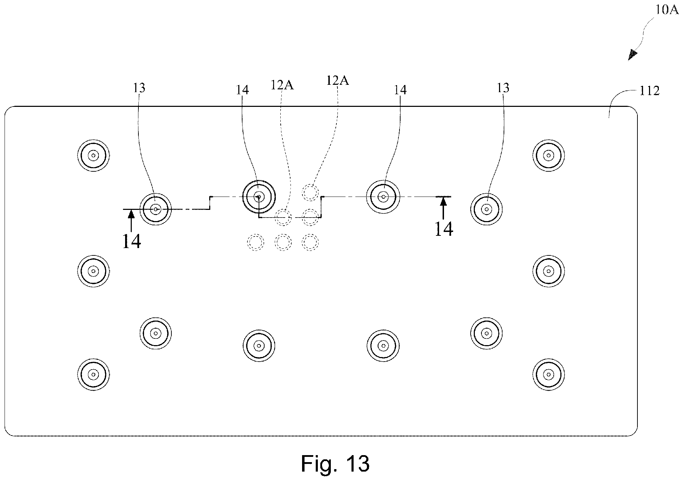

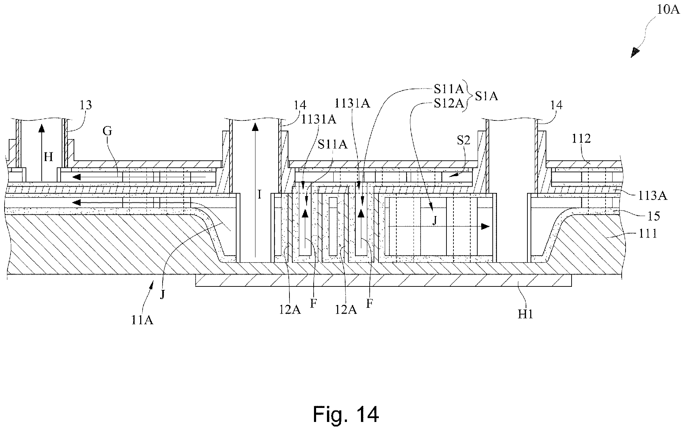

Referring to FIGS. 12-14. FIG. 12 is a schematic plan view of the heat-conducting chamber body of the high heat cooling device of FIG. 9. FIG. 13 is a schematic plan view of the high heat cooling device of FIG. 9. FIG. 14 is a schematic cross-sectional view of a high heat cooling device along line 14-14 of FIG. 13.

In one embodiment, when the heat from the heat source H1 is transferred to the primary hot zones S11A through the heat-absorbing surface 114, the cooling fluid located in the primary hot zones S11A absorbs the heat and vaporizes into a gaseous state, and the vaporized cooling fluid passes through the openings 1131A in the direction F and flows to the second chamber S2. Subsequently, the vaporized cooling fluid flows in the second chamber S2 along the direction G, and then flows from the second chamber S2 along the direction H to the primary hot zone heat pipe 13. Further, when the heat from the heat source H1 is transferred to the secondary hot zone S12A through the heat-absorbing surface 114, the cooling fluid in the secondary hot zone S12A absorbs the heat and vaporizes into a gaseous state, and the vaporized cooling fluid flows from the first chamber S1A to the secondary hot zone heat pipe14 along the direction I and to the secondary hot zone S12A along the direction J.

When the vaporized cooling fluid is cooled and condensed into a liquid state in the primary hot zone heat pipe 13, it flows from the primary hot zone heat pipe 13 to the second chamber S2 in the opposite direction of H. Subsequently, the liquid state working fluid flows in the second chamber S2 in the opposite direction of G, and then flows in the opposite direction of F though the opening 1131A to the primary hot zone S11A to complete the cooling cycle of the primary hot zone S11A, the second chamber S2 and the primary hot zone heat pipes 13. Further, when the vaporized cooling fluid is cooled and condensed into a liquid state in the secondary hot zone heat pipes 14, it flows from the secondary hot zone heat pipe 14 in the opposite direction of I to the first chamber S1A and in the opposite direction of J to the secondary hot zone S12 to complete the cooling cycle of the secondary hot zone S12A and the secondary hot zone heat pipes 14.

In one embodiment, when the power of the heat source is low, the primary hot zone and the secondary hot zone separated by the isolation ring are sufficient to dissipate heat from the heat source. When the power of the heat source is high, the cooling fluid in the second chamber flows into the center of the primary hot zone of the first chamber that is in fluid communication with the second chamber, and the first chamber and the second chamber work together to dissipate heat from the heat source. Accordingly, it could avoid functional degradation of the high heat cooling device caused by partially dry burning and maintain the heat dissipation performance of the high heat cooling device, making the high heat cooling device more efficient. The cooling device may be suitable for heat sources such as higher power wafers.

Specifically, when the power of the primary heat source corresponding to the primary hot zone is greater than or equal to 70% of the total power of the heat source, the primary hot zone can supply a larger power load to increase the heat dissipation efficiency of the heat source because the cooling fluid filling amount of the primary hot zone is greater than that of the secondary hot zone. When the power of the primary heat source corresponding to the primary hot zone is less than 70% of the total power of the heat source, the cooling fluid filling rate through the primary hot zone remains greater than or equal to 60% of the volume of the capillary pore, and the cooling fluid filling amount would be less than or equal to the 80 % of the volume of the first chamber. Accordingly, a mechanism of coexistence of boiling and evaporation can be formed by overfilling the primary hot zone with cooling fluid, thereby preventing the primary hot zone from being partially dry burning due to excessively high temperature of the heat source.

Further, when the external temperature of the high heat cooling device is lower than the freezing point of the cooling fluid in the secondary hot zone S12, the cooling fluid in the secondary hot zone S12 changes to solid state, and the cooling fluid in the primary hot zone S11 can still maintain its liquid state and flow normally. Accordingly, the cooling fluid located in the primary hot zone S11 can heat the solidified cooling fluid in the secondary hot zone S12 so that the cooling fluid in the secondary hot zone S12 could melt into a liquid state and resume normal flow.

In other embodiments, based on the specific design of the fins, the high cooling device may have varying heat exchange efficiencies across different regions. Some areas within the device can be highly effective at transferring heat, while others may be less efficiency. According to the present disclosure, the primary hot zone heat pipes can be strategically positioned in the region with high efficiency of heat exchange. By optimizing the placement of the primary hot zone heat pipes, the device can capitalize on the areas with enhanced thermal conductivity, thereby maximizing the overall efficiency of heat transfer. This approach ensures that the device operates optimally by concentrating heat dissipation efforts where they are most effective, leading to improved performance and reliability of the cooling system.

Therefore, embodiments disclosed herein are well adapted to attain the ends and advantages mentioned as well as those that are inherent therein. The particular embodiments disclosed above are illustrative only, as the embodiments disclosed may be modified and practiced in different but equivalent manners within the scope of the invention as defined in the claims.

## Claims

1. A high heat cooling device (10, 10A), comprising:
a heat-conducting chamber body (11, 11A) having a heat-absorbing surface (114), a first chamber (S1, S1A) and a second chamber (S2), the first chamber (S1, S1A) being arranged closer to the heat-absorbing surface (114) than the second chamber (S2); and
at least one isolation ring (12, 12A) disposed in the first chamber (S1, S1A) of the heat-conducting chamber body (11, 11A) that divides the first chamber (S1, S1A) into a primary hot zone (S11, S11A) and a secondary hot zone (S12, S12A), wherein:
the primary hot zone (S11, S11A) is not in communication with the secondary hot zone (S12, S12A), and **characterized in that**
the primary hot zone (S11, S11A) is surrounded by the isolation ring (12, 12A) and is in communication with the second chamber (S2).

2. The high heat cooling device (10, 10A) according to claim 1, wherein the primary hot zone (S11, S11A) and the secondary hot zone (S12, S12A) are filled with different types of cooling fluid.

3. The high heat cooling device (10, 10A) according to claim 2, wherein the freezing point of the cooling fluid in the primary hot zone (S11, S11A) is lower than that of the cooling fluid in the secondary hot zone (S12, S12A).

4. The high heat cooling device (10, 10A) according to claim 1, wherein a cooling fluid filling rate in the primary hot zone (S11, S11A) is different from that in the secondary hot zone (S12, S12A).

5. The high heat cooling device (10, 10A) according to claim 4, wherein the cooling fluid filling rate in the primary hot zone (S11, S11A) is greater than that in the secondary hot zone (S12, S12A).

6. The high heat cooling device (10, 10A) according to claim 1, wherein the area of the primary hot zone (S11, S11A) is equal to or greater than 5% of the heat source area, and less than or equal to 80% of the heat source area.

7. The high heat cooling device (10, 10A) according to claim 4, wherein the cooling fluid filling rate in the primary hot zone (S11, S11A) is equal or greater than 60% of the volume of the capillary pore, and the cooling fluid filling rate in the secondary hot zone (S12, S12A) is at least 50% of the volume of the capillary pore and does not exceed 130% of the volume of the capillary pore.

8. The high heat cooling device (10, 10A) according to any one of claims 1 to 7, further comprises a plurality of primary hot zone heat pipes (13), wherein the plurality of primary hot zone heat pipes (13) are disposed in the heat-conducting chamber body (11, 11A) and are in fluid communication with the second chamber (S2) and the primary hot zone (S11, S11A) of the first chamber (S1, S1A).

9. The high heat cooling device (10, 10A) according to claim 8, wherein at least one primary hot zone heat pipes (13) is positioned outside of the first region that is an area right above the heat-absorbing surface (114) in the heat-conducting chamber body (11, 11A).

10. The high heat cooling device (10, 10A) according to any one of claims 1 to 9, further comprises a plurality of secondary hot zone heat pipes (14), wherein the secondary hot zone heat pipes (14) are disposed in the heat-conducting chamber body (11, 11A) and communicated to the secondary hot zone (S12, S12A) of the first chamber (S1, S1A).

11. The high heat cooling device (10, 10A) according to claim 10, wherein the secondary hot zone heat pipes (14) are configured to be positioned entirely within the first region, entirely outside of the first region, or in a configuration where some secondary hot zone heat pipes (14) are within in the first region while others are positioned outside of the first region.

12. The high heat cooling device (10) according to claim 8, wherein at least one primary hot zone heat pipe (13) is located on a side of the heat-conducting chamber body (11) along a longitudinal axis (L).

13. The high heat cooling device (10) according to claim 12, wherein the heat-conducting chamber body (11) includes an air inlet side edge (115), and the distance from the air inlet side edge (115) to the nearest primary hot zone heat pipe (13) is less than or equal to one-third of the length of the longitudinal axis of the heat-conducting chamber body (11).

14. The high heat cooling device (10) according to claim 13, wherein a portion of the plurality of primary hot zone heat pipes (13) are located adjacent to the air inlet side edge (115).

15. The high heat cooling device (10) according to claim 1, further comprises a plurality of primary hot zone heat pipes (13), wherein at least one primary hot zone heat pipe (13) is in fluid communication with the primary hot zone (S11), and the number of the primary hot zone heat pipes (13) located on the side adjacent to the air inlet side edge (115) along the longitudinal axis of the heat-conducting chamber body (11) is greater than or equal to 10% of the total number of the primary hot zone heat pipes (13) and the hot zone heat pipes combined together.

16. The high heat cooling device (10, 10A) according to any one of claims 1 to 15, further comprising:
a first heat-conducting casing (111);
a second heat-conducting casing (112); and
at least one partition plate (113, 113A) having at least one opening (1131, 1131A),
wherein:
the partition plate (113., 113A) is arranged between the first-heat conducting casing (111) and the second heat-conducting casing (112),
the first chamber (S1, S1A) and the second chamber (S2) are formed by coupling the first heat-conducting casing (111), the second heat-conducting casing (112) and the partition plate (113, 113A), and the first chamber (S1, S1A) and the second chamber (S2) are located on opposite sides of the partition plate (113, 113A),
the heat-absorbing surface (114) is located on a side of the first heat-conducting casing (111) and is further away from the second heat-conducting casing (112),
the isolation ring (12, 12A) having a first end and a second end connect to the first heat-conducting casing (111) and the partition plate (113, 113A), respectively, and
the primary hot zone (S11, S11A) is communicated to the second chamber (S2) via at least one opening (1131, 1131A).

17. The high heat cooling device (10, 10A) according to claim 16, wherein the thickness of the partition plate (113, 113A) is equal to or greater than 0.1 mm and less than or equal to 5 mm.

18. The high heat cooling device (10, 10A) according to claim 1, wherein a capillary structure (15) is disposed in both the first chamber (S1, S1A) and the second chamber (S2).

19. The high heat cooling device (10, 10A) according to claim 1, wherein a capillary structure (15) is only disposed on the secondary hot zone (S12, S12A) of the first chamber (S1, S1A).

## Patentansprüche

1. Eine Hochleistungs-Kühlvorrichtung (10, 10A), umfassend:
einen wärmeleitenden Kammerkörper (11, 11A) mit einer wärmeabsorbierenden Oberfläche (114), einer ersten Kammer (S1, S1A) und einer zweiten Kammer (S2), wobei die erste Kammer (S1, S1A) näher an der wärmeabsorbierenden Oberfläche (114) angeordnet ist als die zweite Kammer (S2); und
mindestens einen Isolationsring (12, 12A), der in der ersten Kammer (S1, S1A) des wärmeleitenden Kammerkörpers (11, 11A) angeordnet ist und die erste Kammer (S1, S1A) in eine primäre Heißzone (S11, S11A) und eine sekundäre Heißzone (S12, S12A) unterteilt, wobei:
die primäre Heißzone (S11, S11A) nicht mit der sekundären Heißzone (S12, S12A) in Verbindung steht, und
**dadurch gekennzeichnet, dass** die primäre Heißzone (S11, S11A) von dem Isolationsring (12, 12A) umgeben ist und mit der zweiten Kammer (S2) in Verbindung steht.

2. Die Hochleistungs-Kühlvorrichtung (10, 10A) nach Anspruch 1, wobei die primäre Heißzone (S11, S11A) und die sekundäre Heißzone (S12, S12A) mit unterschiedlichen Arten von Kühlfluid gefüllt sind.

3. Die Hochleistungs-Kühlvorrichtung (10, 10A) nach Anspruch 2, wobei der Gefrierpunkt des Kühlfluids in der primären Heißzone (S11, S11A) niedriger ist als der des Kühlfluids in der sekundären Heißzone (S12, S12A).

4. Die Hochleistungs-Kühlvorrichtung (10, 10A) nach Anspruch 1, wobei sich die Füllrate des Kühlfluids in der primären Heißzone (S11, S11A) von der in der sekundären Heißzone (S12, S12A) unterscheidet.

5. Die Hochleistungs-Kühlvorrichtung (10, 10A) nach Anspruch 4, wobei die Füllrate des Kühlfluids in der primären Heißzone (S11, S11A) größer ist als die in der sekundären Heißzone (S12, S12A).

6. Die Hochleistungs-Kühlvorrichtung (10, 10A) gemäß Anspruch 1, wobei die Fläche der primären Heißzone (S11, S11A) mindestens 5 % der Wärmequellenfläche und höchstens 80 % der Wärmequellenfläche beträgt.

7. Die Hochleistungs-Kühlvorrichtung (10, 10A) nach Anspruch 4, wobei die Füllrate des Kühlfluids in der primären Heißzone (S11, S11A) mindestens 60 % des Volumens der Kapillarpore beträgt und die Füllrate des Kühlfluids in der sekundären Heißzone (S12, S12A) mindestens 50 % des Volumens der Kapillarporen beträgt und 130 % des Volumens der Kapillarporen nicht überschreitet.

8. Die Hochleistungs-Kühlvorrichtung (10, 10A) gemäß einem der Ansprüche 1 bis 7 umfasst ferner eine Vielzahl von primären Heißzonen-Wärmerohren (13) für die primäre Heißzone, wobei die Vielzahl von primären Heißzonen-Wärmerohren (13) für die primäre Heißzone im wärmeleitenden Kammerkörper (11, 11A) angeordnet sind und in Fluidverbindung mit der zweiten Kammer (S2) und der primären Heißzone (S11, S11A) der ersten Kammer (S1, S1A) stehen.

9. Die Hochleistungs-Kühlvorrichtung (10, 10A) gemäß Anspruch 8, wobei mindestens ein primäres Heißzonen-Wärmerohr (13) außerhalb des ersten Bereichs positioniert ist, der sich direkt über der wärmeabsorbierenden Oberfläche (114) im wärmeleitenden Kammerkörper (11, 11A) befindet.

10. Die Hochleistungs-Kühlvorrichtung (10, 10A) gemäß einem der Ansprüche 1 bis 9 umfasst ferner eine Vielzahl von sekundären Heißzonen-Wärmerohren (14), wobei die sekundären Heißzonen-Wärmerohre (14) im wärmeleitenden Kammerkörper (11, 11A) angeordnet sind und mit der sekundären Heißzone (S12, S12A) der ersten Kammer (S1, S1A) in Verbindung stehen.

11. Die Hochleistungs-Kühlvorrichtung (10, 10A) gemäß Anspruch 10, wobei die sekundären Heißzonen-Wärmerohre (14) so konfiguriert sind, dass sie vollständig innerhalb des ersten Bereichs, vollständig außerhalb des ersten Bereichs oder in einer Konfiguration angeordnet sind, bei der sich einige sekundäre Heißzonen-Wärmerohre (14) innerhalb des ersten Bereichs befinden, während andere außerhalb des ersten Bereichs angeordnet sind.

12. Die Hochleistungs-Kühlvorrichtung (10) nach Anspruch 8, wobei sich mindestens ein primäres Heißzonen-Wärmerohr (13) auf einer Seite des wärmeleitenden Kammerkörpers (11) entlang einer Längsachse (L) befindet.

13. Die Hochleistungs-Kühlvorrichtung (10) nach Anspruch 12, wobei der wärmeleitende Kammerkörper (11) eine Lufteinlass-Seitenkante (115) aufweist und der Abstand von der Lufteinlass-Seitenkante (115) zum nächstgelegenen primären Heißzonen-Wärmerohr (13) kleiner oder gleich einem Drittel der Länge der Längsachse des wärmeleitenden Kammerkörpers (11) beträgt.

14. Die Hochleistungs-Kühlvorrichtung (10) nach Anspruch 13, wobei ein Teil der mehreren primären Heißzonen-Wärmerohre (13) benachbart an die Lufteinlass-Seitenkante (115) angeordnet ist.

15. Die Hochleistungs-Kühlvorrichtung (10) nach Anspruch 1 umfasst ferner eine Vielzahl von primären Heißzonen-Wärmerohren (13), wobei mindestens ein primäres Heißzonen-Wärmerohr (13) in Fluidverbindung mit der primären Heißzone (S11) steht, und die Anzahl der primären Heißzonen-Wärmerohre (13), die auf der der Lufteinlass-Seitenkante (115) benachbarten Seite entlang der Längsachse des wärmeleitenden Kammerkörpers (11) angeordnet sind, größer oder gleich 10 % der Gesamtzahl der primären Heißzonen-Wärmerohre (13) und der Heißzonen-Wärmerohre zusammen ist.

16. Die Hochleistungs-Kühlvorrichtung (10, 10A) gemäß einem der Ansprüche 1 bis 15, ferner umfassend:
ein erstes wärmeleitendes Gehäuse (111);
ein zweites wärmeleitendes Gehäuse (112); und
mindestens eine Trennlage (113, 113A) mit mindestens einer Öffnung (1131, 1131A), wobei:
die Trennlage (113, 113A) zwischen dem ersten wärmeleitenden Gehäuse (111) und dem zweiten wärmeleitenden Gehäuse (112) angeordnet ist,
die erste Kammer (S1, S1A) und die zweite Kammer (S2) durch das Zusammenfügen des ersten wärmeleitenden Gehäuses (111), des zweiten wärmeleitenden Gehäuses (112) und der Trennlage (113, 113A) gebildet werden, und die erste Kammer (S1, S1A) und die zweite Kammer (S2) befinden sich auf gegenüberliegenden Seiten der Trennlage (113, 113A),
die wärmeabsorbierende Oberfläche (114) befindet sich auf einer Seite des ersten wärmeleitenden Gehäuses (111) und ist weiter vom zweiten wärmeleitenden Gehäuse (112) entfernt,
der Isolationsring (12, 12A) mit einem ersten Ende und einem zweiten Ende jeweils mit dem ersten wärmeleitenden Gehäuse (111) und der Trennlage (113, 113A) verbunden ist, und
die primäre Heißzone (S11, S11A) über mindestens eine Öffnung (1131, 1131A) mit der zweiten Kammer (S2) in Verbindung steht.

17. Die Hochleistungs-Kühlvorrichtung (10, 10A) gemäß Anspruch 16, wobei die Dicke der Trennlage (113, 113A) gleich oder größer als 0,1 mm und kleiner oder gleich 5 mm ist.

18. Die Hochleistungs-Kühlvorrichtung (10, 10A) nach Anspruch 1, wobei sowohl in der ersten Kammer (S1, S1A) als auch in der zweiten Kammer (S2) eine Kapillarstruktur (15) angeordnet ist.

19. Die Hochleistungs-Kühlvorrichtung (10, 10A) gemäß Anspruch 1, wobei eine Kapillarstruktur (15) nur in der sekundären Heißzone (S12, S12A) der ersten Kammer (S1, S1A) angeordnet ist.

## Revendications

1. Dispositif de refroidissement à haute chaleur (10, 10A), comprenant :
un corps de chambres conductrices de chaleur (11, 11A) ayant une surface absorbant la chaleur (114), une première chambre (S1, S1A) et une seconde chambre (S2), la première chambre (S1, S1A) étant disposée plus proche de la surface absorbant la chaleur (114) que la seconde chambre (S2) ; et
au moins un anneau d'isolation (12, 12A) disposé dans la première chambre (S1, S1A) du corps de chambres conductrices de chaleur (11, 11A) qui divise la première chambre (S1, S1A) en une zone chaude primaire (S11, S11A) et une zone chaude secondaire (S12, S12A), dans lequel :
la zone chaude primaire (S11, S11A) n'est pas en communication avec la zone chaude secondaire (S12, S12A), et caractérisé en ce
la zone chaude primaire (S11, S11A) est entourée par l'anneau d'isolation (12, 12A) et est en communication avec la seconde chambre (S2).

2. Dispositif de refroidissement à haute chaleur (10, 10A) selon la revendication 1, dans lequel la zone chaude primaire (S11, S11A) et la zone chaude secondaire (S12, S12A) sont remplies de différents types de fluide de refroidissement.

3. Dispositif de refroidissement à haute chaleur (10, 10A) selon la revendication 2, dans lequel le point de congélation du fluide de refroidissement dans la zone chaude primaire (S11, S11A) est plus bas que celui du fluide de refroidissement dans la zone chaude secondaire (S12, S12A).

4. Dispositif de refroidissement à haute chaleur (10, 10A) selon la revendication 1, dans lequel un taux de remplissage de fluide de refroidissement dans la zone chaude primaire (S11, S11A) est différent de celui de la zone chaude secondaire (S12, S12A).

5. Dispositif de refroidissement à haute chaleur (10, 10A) selon la revendication 4, dans lequel le taux de remplissage de fluide de refroidissement dans la zone chaude primaire (S11, S11A) est supérieur à celui de la zone chaude secondaire (S12, S12A).

6. Dispositif de refroidissement à haute chaleur (10, 10A) selon la revendication 1, dans lequel la surface de la zone chaude primaire (S11, S11A) est égale ou supérieure à 5 % de la surface de source de chaleur, et inférieure ou égale à 80 % de la surface de source de chaleur.

7. Dispositif de refroidissement à haute chaleur (10, 10A) selon la revendication 4, dans lequel le taux de remplissage de fluide de refroidissement dans la zone chaude primaire (S11, S11A) est égal ou supérieur à 60 % du volume du pore capillaire, et le taux de remplissage de fluide de refroidissement dans la zone chaude secondaire (S12, S12A) est égal à au moins 50 % du volume du pore capillaire et ne dépasse pas 130 % du volume du pore capillaire.

8. Dispositif de refroidissement à haute chaleur (10, 10A) selon l'une quelconque des revendications 1 à 7, comprenant en outre une pluralité de conduites de chaleur de zone chaude primaire (13), dans lequel la pluralité des conduites de chaleur de zone chaude primaire (13) sont disposées dans le corps de chambres conductrices de chaleur (11, 11A) et sont en communication fluidique avec la seconde chambre (S2) et la zone chaude primaire (S11, S11A) de la première chambre (S1, S1A).

9. Dispositif de refroidissement à haute chaleur (10, 10A) selon la revendication 8, dans lequel au moins une des conduites de chaleur de zone chaude primaire (13) est positionnée à l'extérieur de la première région qui est une surface juste au-dessus de la surface absorbant la chaleur (114) dans le corps de chambres conductrices de chaleur (11, 11A).

10. Dispositif de refroidissement à haute chaleur (10, 10A) selon l'une quelconque des revendications 1 à 9, comprenant en outre une pluralité de conduites de chaleur de zone chaude secondaire (14), dans lequel les conduites de chaleur de zone chaude secondaire (14) sont disposées dans le corps de chambres conductrices de chaleur (11, 11A) et communiquent avec la zone chaude secondaire (S12, S12A) de la première chambre (S1, S1A).

11. Dispositif de refroidissement à haute chaleur (10, 10A) selon la revendication 10, dans lequel les conduites de chaleur de zone chaude secondaire (14) sont configurées pour être positionnées entièrement dans la première région, entièrement en dehors de la première région, ou selon une configuration dans laquelle certaines conduites de chaleur de zone chaude secondaire (14) sont à l'intérieur de la première région tandis que d'autres sont positionnées en dehors de la première région.

12. Dispositif de refroidissement à haute chaleur (10) selon la revendication 8, dans lequel au moins une conduite de chaleur de zone chaude primaire (13) est située sur un côté du corps de chambres conductrices de chaleur (11) le long d'un axe longitudinal (L).

13. Dispositif de refroidissement à haute chaleur (10) selon la revendication 12, dans lequel le corps de chambres conductrices de chaleur (11) comporte un bord côté entrée d'air (115), et la distance allant du bord côté entrée d'air (115) à la conduite de chaleur de zone chaude primaire (13) la plus proche est inférieure ou égale à un tiers de la longueur de l'axe longitudinal du corps de chambres conductrices de chaleur (11).

14. Dispositif de refroidissement à haute chaleur (10) selon la revendication 13, dans lequel une partie de la pluralité de conduites de chaleur de zone chaude primaire (13) est située à proximité adjacente du bord côté entrée d'air (115).

15. Dispositif de refroidissement à haute chaleur (10) selon la revendication 1, comprenant en outre une pluralité de conduites de chaleur de zone chaude primaire (13), dans lequel au moins une conduite de chaleur de zone chaude primaire (13) est en communication fluidique avec la zone chaude primaire (S11), et le nombre des conduites de chaleur de zone chaude primaire (13) situées sur le côté adjacent au bord côté entrée d'air (115) le long de l'axe longitudinal du corps de chambres conductrices de chaleur (11) est supérieur ou égal à 10 % du nombre total des conduites de chaleur de zone chaude primaire (13) et des conduites de chaleur de zone chaude combinées ensemble.

16. Dispositif de refroidissement à haute chaleur (10, 10A) selon l'une quelconque des revendications 1 à 15, comprenant en outre :
un premier tubage conducteur de chaleur (111) ;
un second tubage conducteur de chaleur (112) ; et
au moins une plaque de séparation (113, 113A) ayant au moins une ouverture (1131, 1131A), dans lequel :
la plaque de séparation (113, 113A) est disposée entre le premier tubage conducteur de chaleur (111) et le second tubage conducteur de chaleur (112),
la première chambre (S1, S1A) et la seconde chambre (S2) sont formées en couplant le premier tubage conducteur de chaleur (111), le second tubage conducteur de chaleur (112) et la plaque de séparation (113, 113A), et la première chambre (S1, S1A) et la seconde chambre (S2) sont situées sur des côtés opposés de la plaque de séparation (113, 113A),
la surface absorbant la chaleur (114) est située sur un côté du premier tubage conducteur de chaleur (111) et est plus éloignée du second tubage conducteur de chaleur (112),
l'anneau d'isolation (12, 12A) a une première extrémité et une seconde extrémité qui se connectent respectivement au premier tubage conducteur de chaleur (111) et à la plaque de séparation (113, 113A), et
la zone chaude primaire (S11, S11A) communique avec la seconde chambre (S2) via au moins une ouverture (1131, 1131A).

17. Dispositif de refroidissement à haute chaleur (10, 10A) selon la revendication 16, dans lequel l'épaisseur de la plaque de séparation (113, 113A) est égale ou supérieure à 0,1 mm et inférieure ou égale à 5 mm.

18. Dispositif de refroidissement à haute chaleur (10, 10A) selon la revendication 1, dans lequel une structure capillaire (15) est disposée à la fois dans la première chambre (S1, S1A) et la seconde chambre (S2).

19. Dispositif de refroidissement à haute chaleur (10, 10A) selon la revendication 1, dans lequel une structure capillaire (15) n'est disposée que sur la zone chaude secondaire (S12, S12A) de la première chambre (S1, S1A).
